# EUROPEAN PATENT APPLICATION

(11) **EP 0 802 457 A1**
(43) Date of publication of application: **22.10.1997**
(21) Application number: 97200833.8
(22) Date of filing: 20.03.1997
(51) Int. Cl.: G03F 7/18, B41C 1/10

(54) **Appartus for making and imaging a lithographic printing plate**

(30) Priority: 16.04.1996 EP 96200932
(71) Applicant: AGFA-GEVAERT naamloze vennootschap, 2640 Mortsel (BE)
(72) Inventor: Vermeersch, Joan, 2640 Mortsel (BE); van Hunsel, Johan, 2640 Mortsel (BE)

(57) **Abstract**

The present invention discloses an apparatus comprising a printing member, means for applying a uniform coating, means for scan-wise exposing the uniform coating in accordance with an image pattern and means for developing the uniform coating to leave an image on the printing member, the image consisting of ink accepting areas on an ink repellant background or ink repellant areas on an ink accepting background characterized in that said printing member comprises a cylinder having mounted thereto a plate having a surface that is ink accepting or ink repellant. The present invention further describes a method for making a lithographic printing member using an apparatus as defined above and a package comprising a coating liquid adapted for use in the apparatus.

## Description

### 1. Field of the invention.

The present invention relates to a method for making a lithographic printing member wherein a printing member is coated, scan-wise exposed according to an image pattern and developed in a single apparatus. The present invention also relates to such apparatus and suitable coating liquids for use therewith.

### 2. Background of the invention

Lithographic printing is the process of printing from specially prepared surfaces, some areas of which are capable of accepting ink (oleophilic areas) whereas other areas will not accept ink (oleophobic areas). The oleophilic areas form the printing areas while the oleophobic areas form the background areas.

Two basic types of lithographic printing plates are known. According to a first type, so called wet printing plates, both water or an aqueous dampening liquid and ink are applied to the plate surface that contains hydrophilic and hydrophobic areas. The hydrophilic areas will be soaked with water or the dampening liquid and are thereby rendered oleophobic while the hydrophobic areas will accept the ink. A second type of lithographic printing plates operates without the use of a dampening liquid and are called driographic printing plates. This type of printing plates comprise highly ink repellant areas and oleophilic areas. Generally the highly ink repellant areas are formed by a silicon layer.

Lithographic printing plates are generally prepared using an imaging element comprising on a support a photosensitive coating. The photosensitive coating is image-wise exposed and developed thereby leaving an image of ink-accepting and ink-repellant areas arranged in an image-wise pattern. Exposure of the photosensitive layer may be done using intermediate photographic films but more recently so called computer to plate systems have gained interest. In the latter system, digital image data is send to an imaging unit that generally comprises a laser to scan-wise expose the imaging element in accordance with the image data.

A well-known disadvantage of photosensitive systems is the fact that they have to be shielded from light before they are imaged which causes handling of such photosensitive plates somewhat more cumbersome. So called heat-sensitive plates have therefore been developed that are generally imaged by means of a laser causing an image-wise heat-pattern in a heat responsive layer of the plate. Such heat may then cause ablative removal of one or more layers or may cause a chemical or physical change in a layer so that subsequent development will result in a lithographic printing plate.

Heat sensitive plates have been described in e.g. FR 2264671, EP 573091, WO 94/18005, US 5385092 etc... The latter further discloses a method wherein the imaging element from which the lithographic printing plate is prepared, is image-wise ablated on the printing press itself so that subsequent to imaging, the printing process can automatically start without further intervention from the operator.

Although the above systems and in particular those involving laser exposure have brought several improvements, the systems still have some disadvantages. For example, most of the above systems require special processing equipement to process the imaging element subsequent to image-wise exposure. Although some of the ablative systems do not require such special equipement, they may cause contamination of the imaging device and require special care and maintenance.

Further, in all of the above systems the imaging elements are produced ready for imaging by a manufacturer. This inherently imposes cost disadvantages and limits flexibility for the printer who is confined to particular formats of imaging elements available from a manufacturer. Moreover, care is generally needed in handling the plates before and after imaging so as not to damage the coatings thereon.

EP 101266 proposes as a solution to the latter problems a method wherein a printing member is uniformly coated with a hydrophobic coating and image-wise ablated, by e.g. a laser, in the printing press itself. However, the proposed solution has the inherent disadvantage of ablative systems as mentioned above and in particular ablated material may contaminate the printing press and impair the printing quality.

GB 1.546.532proposes as solution a method wherein a printing cylinder whereof the surface is covered with a hydrophilic metal is covered with a hudrophobic coazting, exposed through an original in contact with said printing cylinder and developed. However said printing cylinder has to be grained and such printing cylinders are not commercially available.Furthermore said printing cylinder has to be in contact with the original during the exposure what requires a cumbersome handling of the original.

### 3. Summary of the invention

It is an object of the present invention to provide an apparatus and method for making a lithographic printing member wherein coating and imaging of a printing member are carried out in the same apparatus and wherein some of the disadvantages of the prior art are resolved.

Further objects of the present invention will become clear from the description hereinafter.

In accordance with the present invention there is provided an apparatus comprising a printing member, means for applying a uniform coating, means for scan-wise exposing said uniform coating in accordance with an image pattern and means for developing said uniform coating to leave an image on said printing member, said image consisting of ink accepting areas on an ink repellant background or ink repellant areas on an ink accepting background, characterized in that said printing member comprises a cylinder having mounted thereto a plate having a surface that is ink accepting or ink repellant.

The present invention further provides a method for making a lithographic printing member using an apparatus as defined above.

The present invention further provides a package comprising a coating liquid adapted for use in an apparatus as defined above.

### 4. Brief description of the drawings

The present invention is explained and illustrated by means of the following drawings without however the intention to limit the invention thereto.

Figure 1 shows a schematic diagram of an apparatus in accordance with the present invention.

Figure 2 shows a schematic diagram of printing press including an apparatus in accordance with the present invention.

### 5. Detailed description of the invention

### a. apparatus

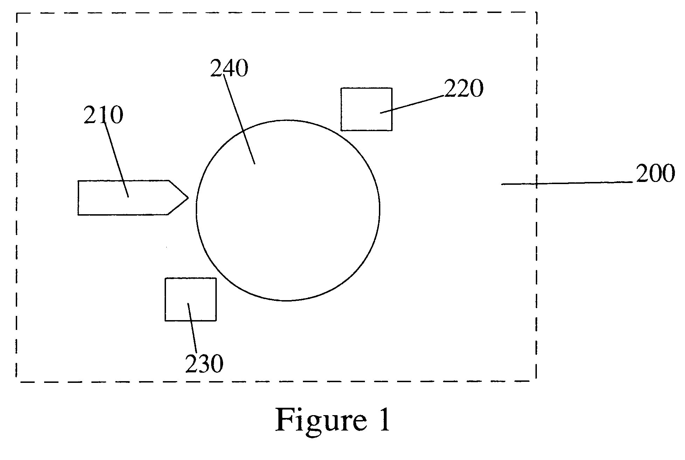

Figure 1 shows a schematic diagram of an apparatus 200 in accordance with the present invention including a printing member 240, means 220 for applying a uniform coating, means 210 for scan-wise exposing the uniform coating in accordance with an image pattern and means 230 for developing the uniform coating to leave an image on the printing member.

A printing member 240 in accordance with the present invention includes a surface that is either ink acceptant or ink repellant relative to the image parts formed from a uniform coating after exposure and development. Thus, in case the image parts are ink acceptant, the surface of the printing member should be ink repellant and in case the image parts are ink repellant, the printing member's surface will be ink acceptant.

In accordance with a particular embodiment, the printing member's surface is hydrophilic and ink repellant towards greasy ink whereas the image parts are hydrophobic and ink acceptant. Examples of hydrophilic surfaces are e.g. grained and anodised aluminium or a hydrophilic binder layer that is preferably cross-linked. A particularly preferred type of hydrophilic binder layer is a hydrophilic polymer, e.g. a polyvinylalcohol, cross-linked by means of a tetraalkylorthosilicate.

In accordance with another embodiment of the present invention, the printing member's surface is ink accepting for a driographic ink and the image parts are ink repellant. Examples of such surfaces are aluminium, steel and plastic films such as polycarbonates and polyesters.

The printing member in accordance with the present invention may take any form but is preferably cylindrical. In accordance with the present invention the printing member includes a printing plate that is reversibly attached to the cylinder. Such printing plate may take the form of a planar surface, a cylinder, an endless belt, etc....

The printing member in accordance with the present invention may be re-usable such that subsequent to printing the image on the printing member's surface may be removed e.g. by a brush, a scraper, a water jet, an automated blanket wash or liquid carbon dioxide.

A means 210 for scan-wise exposure in accordance with the present invention preferably includes a laser (diode) or an array of laser (diodes). According to a highly preferred embodiment in connection with the invention, a infrared laser (diode) is used emitting light of at least 700nm, e.g. a infrared laser diode emitting at 830nm (Gallium-arsenide), a NdYAG laser emitting at 1060nm etc....

A preferred means 210 suitable for image-wise scanning exposure in accordance with the present invention preferably includes a laser output that can be provided directly to the printing members surface via lenses or other beam-guiding components, or transmitted to the surface from a remotely sited laser using a fiber-optic cable. A controller and associated positioning hardware preferably maintains the beam output at a precise orientation with respect to the printing member's surface, scans the output over the surface, and activates the laser at positions adjacent selected points or areas of the printing member. The controller responds to incoming image signals corresponding to the original document and/or picture being copied onto the printing member to produce a precise negative or positive image of that original. The image signals are stored as a bitmap data file on a computer. Such files may be generated by a raster image processor (RIP) or other suitable means. For example, a RIP can accept Input data in page-description language, which defines all of the features required to be transferred onto the printing member, or as a combination of page-description language and one or more image data files. The bitmaps are constructed to define the hue of the color as well as screen frequencies and angles in case of amplitude modulation screening. However, the present invention is particularly suitable for use in combination with frequency modulation screening as disclosed in e.g. EP-A 571010, EP-A 620677 and EP-A 620674.

Means 220 for applying a uniform coating to the printing member include e.g. a spray coater but preferably comprises a train of rolls supplying coating liquid to the printing member to form a uniform coating thereon. In accordance with the present invention, apparatus 200 may include additional means 220 to coat two or more uniform coatings on top of each other.

Means 230 for developing the uniform coating subsequent to scan-wise exposure by means 210, may include any means suitable for selectively removing either the exposed or non-exposed parts. In particular means 230 include e.g. a brush, a water jet or a means for supplying developing liquid to the uniform coating such as e.g. a train of rolls.

An apparatus in accordance with the present invention may be operated in an off press configuration whereby an image is formed on the printing member in such apparatus and subsequently the printing member carrying the image is dismounted from the apparatus and mounted on a printing press to print copies of such image. Alternatively, an apparatus in accordance with the present invention is included in the printing press itself allowing on press coating and imaging.

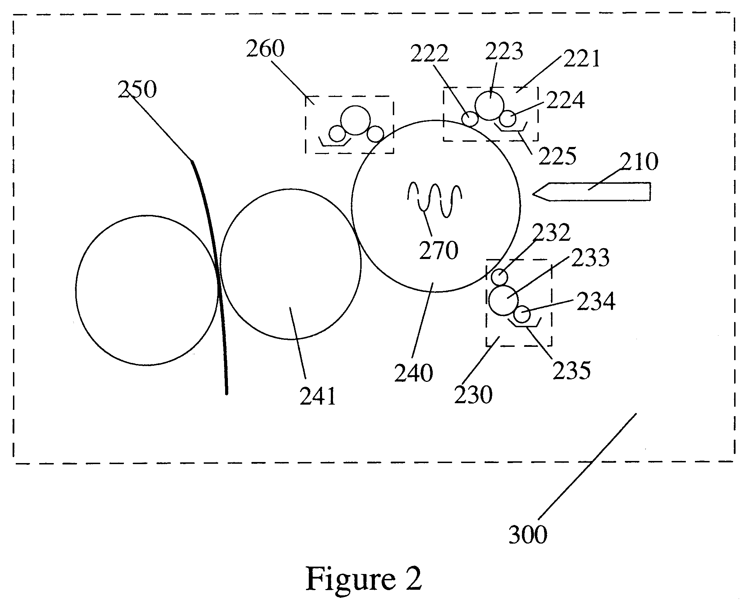

A schematic drawing of a preferred apparatus in accordance with the present invention included in a printing press is shown in figure 2. Printing press 300 includes printing member 240 and means 210 for scan-wise exposure. Means 221 for applying a uniform coating preferably comprise a container 225 holding a coating liquid and rolls 222-224 for supplying coating liquid to printing member 240. Means 221 preferably include means for moving coating means 221 to and from the printing member so that subsequent to coating means 221 can be moved away allowing for drying of the applied uniform coating. To accelarate drying of the coating, an apparatus (200, 300) in accordance with the present invention may include a drying means such as a heating means 270 included in printing member 240. Alternatively, a drying means may be used that is arranged opposite the printing member and that blows air that may be heated or not.

Subsequent to the application of the uniform coating, the uniform coating is scan-wise exposed by means 210 and is then developed by means 231. Means 231 preferably include a container 235 holding a developing liquid and rolls 232-234 for supplying the developing liquid to the printing member thereby selectively dissolving parts of the uniform coating so as to leave an image.

Means 260 supply ink to an image thus formed on the printing member. Means 260 conveniently include a container for holding ink and a train of rollers to supply ink to the printing member. Figure 2 illustrates a train of rollers consisting of 3 rollers, it is however clear that the number of rollers may vary in number, size, diameter and type of surface. Moreover, the train of rollers may comprise more than one roller supplying ink to the printing member so that ink may be distributed more uniformly thereon. The ink thus supplied will selectively adhere to the ink accepting areas and is transferred via a blanket cylinder 241 to receiving sheet 250, e.g. a paper sheet. Cylinder 241 preferably has a compressible surface such as for example a rubber.

In case lithographic printing is carried with the aid of a dampening liquid, a further container and rollers for supplying the dampening liquid to the printing member may be included in a printing press in accordance with the present invention. However, in accordance with a particular embodiment in connection with present invention, the uniform coating is developable by the aqueous dampening fluid such that no additional train of rollers is needed. Alternatively, means 221 may include two containers 225 that can be interchanged and hold the coating liquid and developing liquid respectively. Subsequent to coating and imaging, the container holding the coating liquid can be substituted with the container holding the developing liquid so that development can take place.

In accordance with a highly preferred embodiment means 210 for scan-wise exposure, means 220,221 for applying a uniform coating, means 230,231 for development and means 260 for supplying ink are automatically operated under the control of a suitable computing means (not shown). Further, said computing means may also control the amount of ink supplied to said printing member in accordance with the image content that has been exposed on the printing member.

Further, in accordance with a particular embodiment of the present invention, a re-usable printing member is used and a cleaning means (not shown) is provided near the printing member. Such cleaning means can be a brush, a water jet or a scraper.

### b. coating fluid

Coating fluids for use in connection with the present invention are generally solvent based coatings. Although organic solvents can be used, aqueous based coatings are preferred in connection with the present invention. A coating fluid for use in the present invention includes an active compound that induces or forms a latent image upon exposure by means 210. Depending upon the type of active compound, the coating resulting from a coating liquid in connection with the present invention can be photosensitive or heat-sensitive. Coatings of the latter type are particularly preferred in connection with the present invention.

Photosensitive coatings suitable for use in the present invention are e.g. coatings based on a diazo resin, diazonium salt, aryldiazosulfonate or o-quinone diazide. Photopolymerisable or photocurable coatings. Further examples of suitable coatings are disclosed in US 3.849.137, Macromolecues 1988, 21, 1475-82, US 4.963.463 and US 5.102.771.

Heat sensitive coatings for use in connection with the present invention preferably include a compound capable of converting light into heat. Examples of such compounds are dyes and in particular infrared dyes, carbon black, metal carbides, borides, nitrides, carbonitrides, bronze-structured oxides and oxides structurally related to the bronze family but lacking the A component e.g. WO_{2.9}. It is also possible to use conductive polymer dispersion such as polypyrrole or polyaniline-based conductive polymer dispersions. The compound capable of converting light into heat may instead or in addition to being present in the coating liquid be included in a surface layer of the printing member.

Upon exposure to light with exposure means 210, light is locally converted into heat by the above compound and accordingly an image-wise heat pattern is generated in the coating. As a consequence, a physical or chemical change takes place at the heated parts of the coatings such that subsequent development results in an image.

Various physical and/or chemical changes can be employed. For example the generated heat may induce local cross-linking thereby rendering the coating insoluble at these areas. Alternatively, a coating may be locally rendered hydrophobic thereby causing the exposed areas to be insoluble in an aqueous liquid. A particularly preferred coating liquid for use in the present invention is an aqueous liquid comprising a hydrophilic binder, a compound capable of converting light to heat and hydrophobic thermoplastic polymer particles. A coating resulting from such liquid will be hydrophilic in nature and can be rendered image-wise hydrophobic through coagulation of the thermoplastic polymer particles so that development with an aqueous liquid or plain water may result in an image.

Suitable hydrophilic binders for use in this embodiment in connection with this invention are for example synthetic homo or copolymers such as a polyvinylalcohol, a poly(meth)acrylic acid, a poly(meth)acrylamide, a polyhydroxyethyl(meth)acrylate, a polyvinylmethylether or natural binders such as gelatin, a polysacharide such as e.g. dextran, pullulan, cellulose, arabic gum, alginic acid.

Hydrophobic thermoplastic polymer particles used in connection with the present invention preferably have a coagulation temperature above 35°C and more preferably above 50°C. Coagulation may result from softening or melting of the thermoplastic polymer particles under the influence of heat. There is no specific upper limit to the coagulation temperature of the thermoplastic hydrophobic polymer particles, however the temperature should be sufficiently below the decomposition of the polymer particles. Preferably the coagulation temperature is at least 10°C below the temperature at which the decomposition of the polymer particles occurs. When said polymer particles are subjected to a temperature above coagulation temperature they coagulate to form a hydrophobic agglomerate in the hydrophilic layer so that at these parts the hydrophilic layer becomes insoluble in plain water or an aqueous liquid.

Specific examples of hydrophobic thermoplastic polymer particles for use in connection with the present invention are e.g. polyethylene, polyvinyl chloride, polymethyl (meth)acrylate, polyethyl (meth)acrylate, polyvinylidene chloride, polystyrene polyacrylonitrile, polyvinyl carbazole etc. or copolymers thereof. Most preferably used is polystyrene. The weight average molecular weight of the polymers may range from 5,000 to more than 1,000,000g/mol.

The hydrophobic thermoplastic particles may have a particle size from 0.01µm to 50µm, more preferably between 0.04µm and 10µm and most preferably between 0.04µm and 1µm.

The hydrophobic thermoplastic polymer particles are present as a dispersion in the aqueous coating liquid and may be prepared by the methods disclosed in US-P-3.476.937. Another method especially suitable for preparing an aqueous dispersion of the thermoplastic polymer particles comprises:
- dissolving the hydrophobic thermoplastic polymer in an organic water immiscible solvent,
- dispersing the thus obtained solution in water or in an aqueous medium and
- removing the organic solvent by evaporation.

In addition to the hydrophobic thermoplastic polymer particles, an aqueous coating as described above may include a compound that upon heating causes cross-linking of the hydrophilic binder. In this case a hydrophilic binder should be used that includes reactive groups. Examples of such binders are preferably those that contain reactive groups e.g. hydroxy, amine or carboxyl groups. Specific examples of hydrophilic binders are synthetic homo or copolymers such as a polyvinylalcohol, dimethylhydantoine-formaldehyde resin, a poly(meth)acrylic acid, a poly(meth)acrylamide, a polyhydroxyethyl(meth)acrylate, a polyvinylmethylether or natural binders such as gelatin, a polysacharide such as e.g. dextran, pullulan, cellulose, arabic gum, alginic acid.

Suitable heat-activatable cross-linking agents for use in a coating liquid in connection with the present invention are preferably compounds that have two or more groups that can react with the hydrophilic binder, e.g. with one of the reactive groups listed above. A cross-linking agent in connection with the present invention may be a low molecular weight compound or may be an oligomer or polymer. Examples of suitable cross-linking agents for use in accordance with the present invention are e.g. aldehydes such as formaldehyde, hexamethoxymethyl melamine, amine-formaldehyde resins such as e.g. melamine-formaldehyde resin or guanamine-formaldehyde resin, dimethylolurea-formaldehyde resins, phenol-formaldehyde resins, compounds having two or more expoxy groups e.g. a polymer having epoxy groups etc...

It is preferred in connection with the present invention to further add a catalyst to a coating liquid in connection with the present invention. Such catalyst will speed-up the cross-linking reaction and accordingly total plate making time can be reduced while maintaining a high level of cross-linking preferred to obtain a high printing endurance. Particularly suitable catalysts for use in this context are acid catalysts. It may furthermore be advantageous to use a precursor of a catalyst so as to improve the selectivity of the process and to obtain the best lithographic performance. Such a precursor will convert to the actual catalyst upon heating i.e. the catalyst will be formed at least partially during the image-wise exposure.

Suitable precursors of a catalyst are for example precursors that release an acid upon heating. Particular examples of suitable acid releasing catalyst precursors are diazoniums, sulfonium compounds, in particular benzylsulfonium compounds, as disclosed in e.g. EP 612065, EP 615233, and US 5.326.677, inorganic nitrates such as e.g. Mg(NO₃)₂.6H₂O or organic nitrates such as guanidinium nitrate, ammonium nitrate, pyridinium nitrate etc... as disclosed in EP 462763, WO 81/1755, US 4.370.401, compounds that release a sulfonic acid such as 3-sulfolenes, e.g. 2,5-dihydrothio-thiophene-1,1-dioxides as disclosed in US 5.312.721, thermolytic compounds disclosed in GB 1.204.495, co-cristalin adducts of an amine and an volatile organic acid as disclosed in US 3.669.747, aralkylcyanoforms as disclosed in US 3.166.583, thermo-acids disclosed in EP 159725 and DE 3515176, squaric acid generating compounds as disclosed in US 5.278.031, acid generating compounds disclosed in US 5.225.314 and US 5.227.277 and RD 11511 of November 1973.

Depending upon the relative sensitivity of coagulation of the thermoplastic hydrophobic polymer particles versus cross-linking or image-wise release of a catalyst, either coagulation, cross-linking or release of a catalyst may take place or it is even possible that several processes take place at the same time. If one of the processes has not taken place or only to a minor extent a subsequent overall heating may complete the process so that lithographic performance may be improved thereby. Such overall heating step may be carried out subsequent to scan-wise exposure and/or subsequent to development.

For example the scan-wise exposure may release a catalyst for a cross-linking reaction without causing coagulation and cross-linking. As a consequence, there will be no or little differentiation in the uniform coating to allow development. An overall heating of the uniform coating may then cause sufficient cross-linking to allow development. Subsequent to development a further overall heat treatment at a higher temperature may improve the hydrophobic properties of the image-parts by coagulation of the thermoplastic polymer particles.

Instead of the above hydrophobic thermoplastic polymer particles, it is also possible to use particles comprising polysiloxane. Upon coagulation as described above, highly ink-repellant and water repellant areas can be produced so that a subsequent development with an aqueous liquid or water may result in ink-repellant image-areas.

As a still further alternative, hydropobic polymer particles may be used that include cross-linkable groups. Such hydrophobic polymer particles need not be thermoplastic but can be insolubilised by a heat activated cross-linking.

Further coating liquids suitable for coating a heat sensitive uniform coating in connection with the present invention are disclosed in e.g. EP 625,728; US 5.340.699 and US 4.708.925.

Still further coating liquids suitable for coating a heat sensitive uniform coating include a diazonium salt or a diazo resin and a light to heat converting substance. Upon heating, such coating may be cross-linked and become hydrophobic at the exposed parts so that by an aqueous development the non-exposed parts may be selectively removed.

A coating liquid for use in connection with the present invention is preferably packaged in a suitable form for transportation from e.g. the manufacturer to the customer. An example of a suitable package is e.g. a plastic bottle. The coating liquid may be contained in the package in a ready to use form or may be provided in a concentrated form requiring delution before use. Further, the package may include only the active compounds of the coating liquid without its solvent so that before use these active compounds have to be dissolved.

The invention will be further illustrated by way of the following examples without however the intention to limit the invention thereto. All parts are by weight unless otherwise stated.

### EXAMPLE 1

### Preparation of a lithographic base

A 0.2mm thick aluminium foil was degreased by immersing the foil in an aqueous solution containing 5g/l of sodium hydroxide at 50°C and rinsed with demineralised water. The foil was then electrochemically grained using an alternating current in an aqueous solution containing 4g/l of hydrochloric acid, 4 g/l of hydroboric acid and 0.5g/l of aluminium ions at a temperature of 35°C and a current density of 1200 A/m² to form a surface topography with an average center-line roughness Rₐ of 0.5µm.

After rinsing with demineralised water the aluminium foil was then etched with an aqueous solution containing 300g/l of sulfuric acid ate 60°C for 180 seconds and rinsed with demineralised water at 25°c for 30 seconds.

The foil was subsequently subjected to anodic oxidation in an aqueous solution containing 200 g/l of sulfuric acid at at temperature of 45°c, a voltage of about 10V and a current density of 150 A/m² for about 300 seconds to form an anodic oxidation film of 3g/m² Al₂O₃, then washed with demineralised water, post treated with a solution containing 20 g/l of sodium bicarbonated at 40°C for 30s, subsequently rinsed with demineralised water of 20°C during 120s and dried.

The obtained lithographic base was submersed in an aqueous solution containing 5% by weight of citric acid, brought to pH=7 with sodium hydroxide, for 60s, rinsed with demineralised water and dried at room temperature.

### Preparation of the coating liquid.

To 75g of a 20% dispersion of polymethylmethacrylate (average particle diameter of 90nm) stabilised with Hostapal B (1% vs. polymer) in deionised water was subsequently added, 200g of a 1% solution of "Saure Blaugrun 780 Pina" (Riedel- DeHaen) and 60g of a 5% solution of a 98% hydrolysed polyvinylacetate having a weight average molecular weight of 200.000 g/mol.

### Preparation of the lithographic printing member

The above described lithographic base was mounted on a printing press including a dampening system. The dampening liquid in the dampening system was replaced with a coating liquid as described above. The coating liquid was then applied to the lithographic base by dropping the dampening rollers on the lithographic base and rotating the print cylinder to which the lithographic base was attached for about 100 revolutions. The coating was then allowed to dry at room temperature and was subsequently scan-wise exposed by means of a scanning infrared laser diode at 830nm (scanspeed 1m/s, spot size 10µm and 120mW power at the plate surface).

Subsequently the coating liquid was replaced with an aqueous dampening liquid and the uniform coating was then developed by dropping the dampening rollers on the uniform coating while rotating the print cylinder for 10 revolutions. Subsequently the ink rollers were dropped and after about a further 5 revolutions the first copies of good quality were obtained.

### EXAMPLE 2

The procedure of EXAMPLE 1 was repeated with the exception that as a lithographic base there was used a lithographic base prepared as follows.

To 398 g of a dispersion contg. 21.5% TiO₂ (average particle size 0.3 to 0.5 µm) and 2.5% polyvinyl alcohol in deionized water were subsequently added, while stirring, 195 g of a hydrolyzed 22% tetramethylorthosilicate emulsion in water and 12 g of a 10% solution of a wetting agent.

To this mixture was added 395 g of deionized water and the pH was adjusted to pH=4.

The obtained dispersion was coated on a polyethyleneterephthalate film support (coated with a hydrophilic adhesion layer) to a wet coating thickness of 50 g/m², dried at 30 °C. and subsequently hardened by subjecting it to a temperature of 57 °C for 1 week.

## Claims

1. An apparatus comprising a printing member, means for applying a uniform coating, means for scan-wise exposing said uniform coating in accordance with an image pattern and means for developing said uniform coating to leave an image on said printing member, said image consisting of ink accepting areas on an ink repellant background or ink repellant areas on an ink accepting background characterized in that said printing member comprises a cylinder having mounted thereto a plate having a surface that is ink accepting or ink repellant.

2. An apparatus according to claim 1 further comprising means for applying ink to an image formed on said printing member.

3. An apparatus according to claim 1 or 2 further comprising means for applying an aqueous dampening liquid to an image formed on said printing member.

4. An apparatus according to any of the above claims wherein said printing member comprises a cylinder having mounted thereto a plate having a hydrophilic surface.

5. An apparatus according to any of the above claims wherein said printing member is re-usable.

6. An apparatus according to claim 5 wherein said apparatus includes a means for removing an image formed on said printing member.

7. An apparatus according to any of the above claims wherein said means for scan-wise exposure comprises a laser or an array of lasers.

8. An apparatus according to claim 7 wherein said laser or lasers emit light having a wavelength of at least 700nm.

9. An apparatus according to claim 1 or any of claims 4 to 8 wherein said means for developing comprises means for applying ink to said printing member and/or means for applying an aqueous dampening liquid to said printing member.

10. An apparatus according to any of the above claims further comprising a means for overall heating said uniform coating.

11. A method for making a lithographic printing member comprising in the order given the steps of:
(i) providing an apparatus as defined in any of the above claims
(ii) uniformly applying a coating to said printing member by means of said applying means;
(iii) scan-wise exposing said coating by means of said means for scan-wise exposing ;
(iv) developing said coating by means of said means for developing.

12. A method according to claim 11 wherein said coating is applied from an aqueous coating liquid.

13. A method according to claim 12 wherein said aqueous coating liquid comprises hydrophobic polymer particles.

14. A method according to claim 13 wherein said coating liquid further comprises a hydrophilic binder and a substance capable of converting light to heat and said hydrophobic polymer particles are thermoplastic.

15. A method according claim 14 further comprising a substance capable of causing cross-linking of said uniform coating upon heating.

16. A method according to claim 15 wherein said apparatus is an apparatus as defined in claim 10 and wherein said uniform coating is overall heated subsequent to said development and/or subsequent to said scan-wise exposure.

17. A method for printing one or more copies of an image comprising the steps of:
(i) providing a lithographic printing member according to a method as defined in any of claims 11 to 16;
(ii) applying ink and optionally an aqueous dampening liquid to said lithographic printing member;
(iii) and transfering ink from said lithographic printing member in an image-wise pattern to said receiver sheet.

18. A method according to claim 17 wherein making a lithographic printing member and printing are carried out in an apparatus as defined in any of claims 2, 3 or 9.
